# FASCICULE DE BREVET EUROPEEN

(11) **EP 0 975 979 B1**
(45) Date de publication et mention de la délivrance du brevet: **22.08.2001**
(21) Numéro de dépôt: 98920596.8
(22) Date de dépôt: 09.04.1998
(51) Int. Cl.: G01R 1/067, G01R 1/073

(54) **PROCEDE DE FABRICATION D'UNE CARTE A POINTES DE CONTACT MULTIPLE POUR LE TEST DES PUCES SEMICONDUCTRICES**
VERFAHREN ZUR HERSTELLUNG VON KARTEN MIT MEHREREN KONTAKTSPITZEN ZUM TESTEN VON HALBLEITERCHIPS
METHOD FOR MAKING CARDS WITH MULTIPLE CONTACT TIPS FOR TESTING SEMICONDUCTOR CHIPS

(30) Priorité: 10.04.1997 FR 9704635
(43) Date de publication de la demande: 02.02.2000
(73) Titulaire: Mesatronic, 38430 Saint Jean de Moirans (FR)
(72) Inventeur: BELMONT, André, F-38490 La Batie Divisin (FR); REYNAUD, Vincent, F-38100 Grenoble (FR); DANIAU, William, F-25000 Besançon (FR)
(74) Mandataire: Hecké, Gérard
(86) Numéro de dépôt international: FR9800718
(87) Numéro de publication internationale: WO9845716

(56) Documents cités:
- WO-A-89/11659
- WO-A-96/36884
- US-A- 5 177 438
- US-A- 5 475 318
- LEUNG J ET AL: "ACTIVE SUBSTRATE MEMBRANE PROBE CARD" TECHNICAL DIGEST OF THE INTERNATIONAL ELECTRON DEVICES MEETING (IEDM), WASHINGTON, DEC. 10 - 13, 1995, 10 décembre 1995, pages 709-712, XP000624791 INSTITUTE OF ELECTRICAL AND ELECTRONIC ENGINEERS

## Description

### Domaine technique de l'invention

L'invention est relative à un procédé de fabrication d'une carte à pointes multiple, destinée notamment à tester les puces semiconductrices ou des circuits intégrés avant leur encapsulation, et comprenant un substrat dont l'une des faces est dotée de pistes conductrices connectées à des contacts en forme de pointes.

### Etat de la technique

Les cartes à pointes sont utilisées pour le contrôle des puces ou circuits intégrés après fabrication, et avant leur encapsulation. Les cartes connues à ce jour utilisent généralement différents types de technologies, à savoir les cartes à pointes à lames soudées, les cartes à anneaux époxy, et les cartes à membranes, telles que décrites dans les documents EP-A-0475050, WO9409374, et EP-0646800. La mise en place des pointes sur ces cartes connues est néanmoins limitée à un nombre donné de pointes, lequel n'est plus adapté à l'évolution de l'intégration des puces semiconductrices.

Le document WO 96/36884 décrit un procédé de fabrication d'une carte faisant l'objet d'une découpe préalable pour obtenir un système de lamelles flexibles. Les pistes de connexion ne sont pas monocouches, et ne fait pas usage d'une gravure anisotrope d'un substrat monolithique.

### Objet de l'invention

Un premier objet de l'invention consiste à élaborer un procédé de fabrication d'une carte à pointes multiple permettant d'augmenter la précision et la densité d'implantation des contacts.

Le procédé de fabrication est caractérisé par les étapes suivantes :
- une couche mince métallique est déposée par évaporation sous vide ou par pulvérisation cathodique sur l'une des faces isolée du substrat monolithique, une gravure anisotrope du substrat de silicium étant réalisée avant l'obtention des pistes conductrices, ladite gravure étant non débouchante pour constituer une prise de contact électrique
- les pistes conductrices sont obtenues par gravure directe,
- on réalise par la suite une opération de photolithographie UV consistant à déposer une couche épaisse de résine photosensible sur la couche mince gravée, la résine étant ensuite révélée avec le dessin des pointes,
- on fabrique les pointes par électroformage au moyen d'un bain d'ions métalliques permettant d'obtenir des plots électroformés correspondant à la forme des dessins,
- et la couche restante de résine est finalement dissoute dans un bain de solvant pour obtenir l'implantation définitive des pointes sur le substrat monolithique.

La gravure anisotrope est obtenue avantageusement par immersion du substrat de silicium dans de la potasse KOH.

Selon une caractéristique du procédé, la gravure anisotrope du substrat intervient après une première photolithographie UV consistant à produire à travers un masque une insolation locale d'une couche de résine photosensible enduite préalablement sur une des faces du substrat.

La couche mince métallique peut être formée à titre d'exemple par un matériau à base de nickel, d'or, ou d'aluminium. Tout autre matériau métallique conducteur peut bien entendu être utilisé.

Un deuxième objet de l'invention consiste également à réaliser une carte à pointes multiple, dans laquelle le pas entre les différentes pointes est réduit au minimum, de manière à obtenir une haute densité de contacts.

Les pointes obtenues par une photolithographie UV épaisse et un électroformage, sont formées par des plots métalliques de 10 à 100 microns de diamètre, et de 10 à quelques dizaines de microns d'épaisseur. Les sections des plots peuvent également être de sections carrées ou polygonales.

Chaque pointe est déposée sur la couche mince conductrice, avec ou sans ancrage dans le substrat. Le substrat peut être équipé d'un matériau amortisseur agencé sous la couche mince conductrice à l'opposé de la pointe correspondante.

### Description des figures

D'autres avantages et caractéristiques ressortiront plus clairement de la description du procédé de fabrication qui va suivre, ainsi que des différentes formes de réalisation des pointes illustrées aux dessins annexés, dans lesquels
- la figure 1 montre une carte obtenue selon le procédé de l'invention ;
- la figure 2 représente une vue générale en coupe verticale du substrat équipé des pointes électroformées ;
- la figure 3 est une vue en plan de la figure 2 ;
- les figures 4 à 7 montrent différentes formes de pointes en fonction de l'application de la carte ;
- les figures 8 à 10 représentent différents moyens de liaison électrique et mécanique des pointes sur le substrat ;
- la figure 11 montre une variante de la figure 1, avec un substrat à trous métallisés pour ramener la connexion électrique sur la face opposée aux pointes.
- la figure 12 montre un exemple des différentes étapes a-m chronologiques mises en oeuvre lors du procédé de fabrication selon l'invention;

### Description d'un mode de réalisation préférentiel

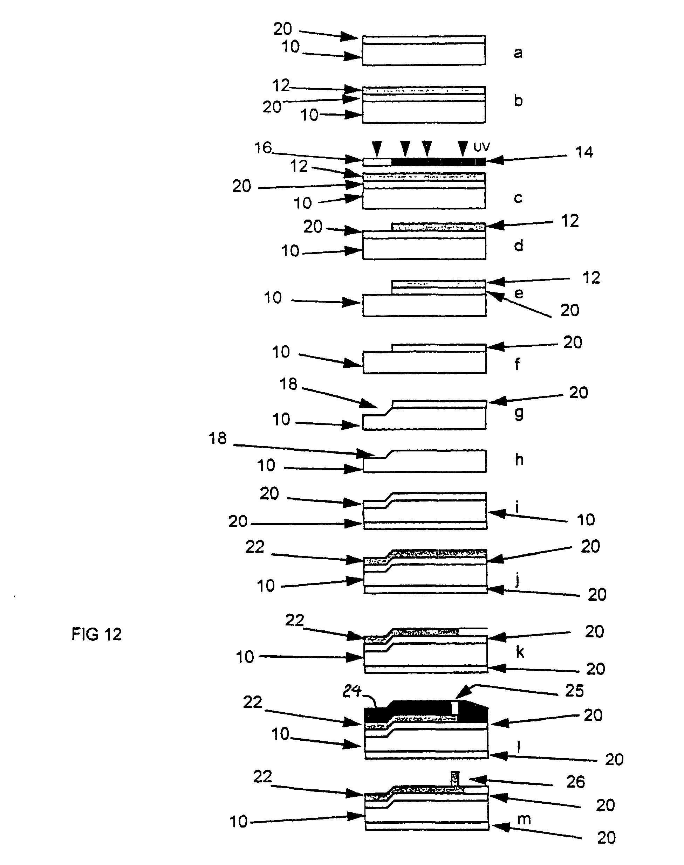

Les différentes étapes de l'exemple de procédé pour la mise en oeuvre de la carte à pointes multiple pour le contrôle des puces après fabrication, sont illustrées sur le schéma de la figure 12 à titre indicatif.

Etape a : On part d'un substrat 10 monolithique en silicium oxydé en formant une couche isolante 20. Le substrat est compatible avec la technique de photolithographie UV permettant d'obtenir des précisions requises, notamment inférieures au micron. D'autres matériaux peuvent bien entendu être utilisés pour réaliser le substrat 10, notamment l'Arsenium Galium As Ga, le quartz, le verre.

Etape b : Une résine 12 photosensible est enduite sur le substrat 10, de manière à obtenir une couche uniforme.

Etape c : On réalise ensuite une première opération de photolithographie UV, consistant à produire une insolation locale de la résine 12 de la couche supérieure à travers un masque 14 ayant un trou 16 d'une forme prédéterminée. Le rayonnement UV est engendré au moyen d'une lampe à ultra-violet disposée au dessus du masque 14.
Etape d : la résine 12 insolée est dissoute au moyen d'un solvant.
Etape e : l'oxyde de silicium de la couche 20 est dissout aux endroits dégagés par la résine 12.
Etape f : La résine 12 est dissoute au moyen d'un solvant.

Etape g : On effectue ensuite une gravure humide anisotrope du silicium 10 après immersion du substrat dans de la potasse KOH. Il en résulte une gravure 18 non débouchante du substrat pouvant atteindre une profondeur d'environ 200 microns, et constituant par la suite une prise pour un contact électrique.

Etape h : L'oxyde de silicium 20 restant sur le substrat 10 est éliminée dans un bain de solvant. Il reste le substrat 10 avec sa gravure 18.

Etape i : On réalise une oxydation thermique du substrat 10 de silicium, de manière à obtenir deux couches 20 isolantes d'oxyde de silicium SiO2 sur les deux faces du substrat 10.

Etape j : Une couche mince métallique 22, par exemple du nickel, de l'or ou de l'aluminium, est ensuite déposée sur toute la surface de la couche isolante 20 supérieure. Le dépôt de cette couche 22 métallique s'effectue par évaporation sous vide, ou par pulvérisation cathodique .

Etape k : Cette étape comporte une deuxième opération de photolithographie UV selon le principe exposé aux étapes b et c, et une gravure de la couche métallique 22 suivant l'endroit et la forme des pointes à réaliser.

Etape I: On réalise ensuite une troisième opération de photolithographie UV après avoir déposé sur la couche métallique 22 gravée, une épaisse couche 24 de résine photosensible, laquelle est révélée avec le dessin des pointes. L'opération de photolithographie est suivie par une opération d'électroformage consistant à fabriquer les pointes 26 sous la forme de plots métalliques de 30 microns de diamètre, et de 60 à 100 microns d'épaisseur. Le matériau des plots électroformés est ici identique à celui de la couche métallique 22 gravée.

Etape m: La couche 24 de résine est finalement dissoute dans un bain de solvant, et on obtient la forme définitive de l'implantation de la pointe 26 sur le substrat 10 monolithique.

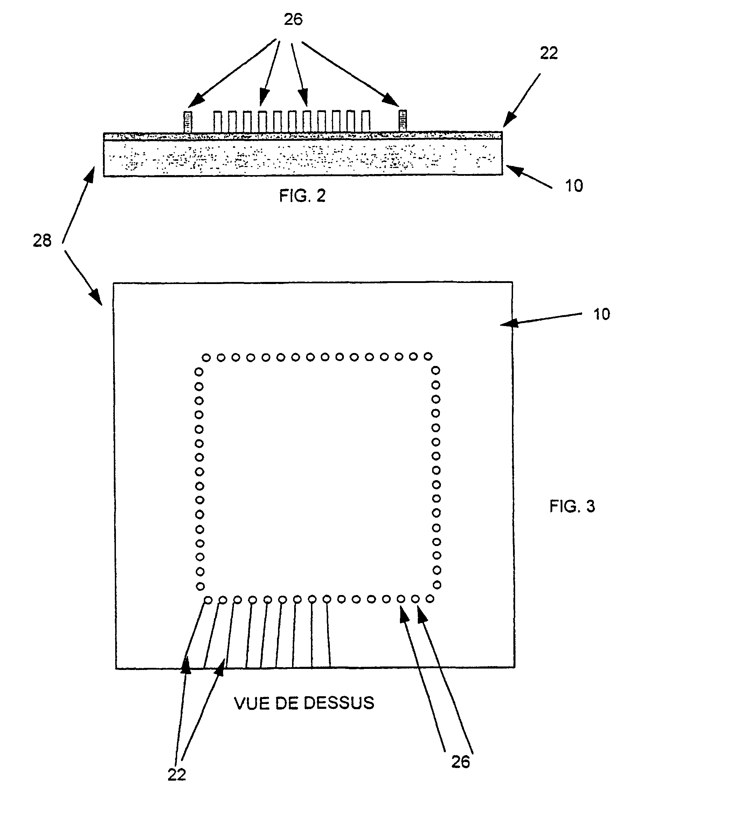

Sur les figures 2 et 3, la carte 28 à pointes multiple comporte une densité élevée de pointes 26 grâce à la technologie de photolithographie, le pas entre les différentes pointes 26 électrodéposées pouvant être de quelques dizaines de microns.

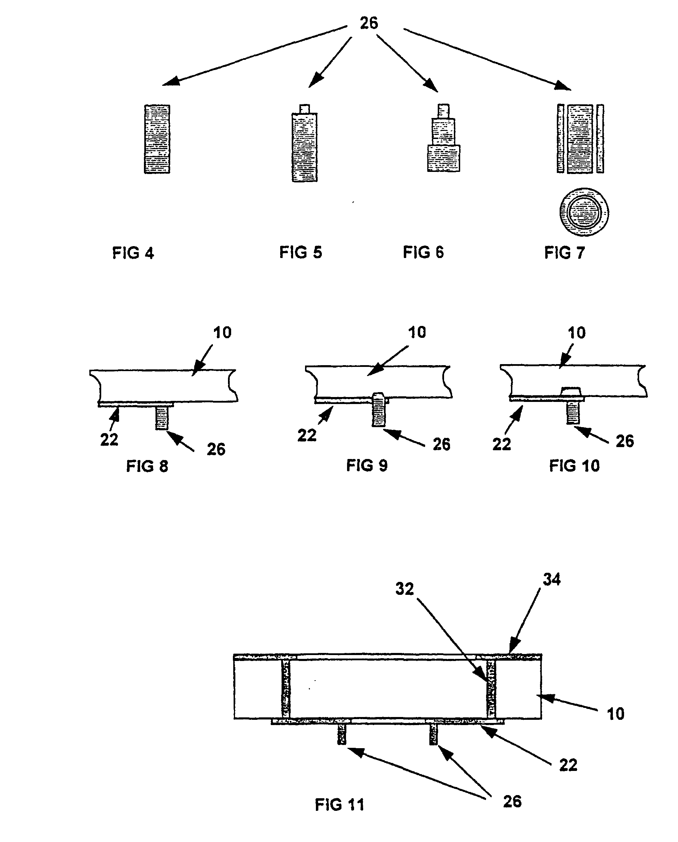

En référence aux figures 4 à 7, les pointes 26 peuvent avoir différentes formes cylindriques à base quelconque, notamment un cylindre droit à section constante (figure 4), deux cylindres superposés (figure 5) ayant éventuellement des matériaux différents, une superposition de cylindres à diamètres décroissants dans le sens de la hauteur (figure 6), et une forme coaxiale (figure 7) pour un test en fréquence. D'autres sections (carrées, polygonales) sont également possibles.

Les divers moyens de liaison électrique et mécanique des pointes 26 sur le substrat 10 sont illustrés sur les figures 8 à 10.

A la figure 8, la pointe 26 est déposée directement sur la couche mince du conducteur 22, en s'étendant selon une direction perpendiculaire au substrat 10.

A la figure 9, la base de la pointe 26 est ancrée dans le substrat 10 en traversant le conducteur 22.

A la figure 10, un matériau amortisseur 30 est agencé dans le substrat 10 et sous le conducteur 22. La base de la pointe 26 est fixée sur la face opposée extérieure du conducteur 22 comme dans la figure 8.

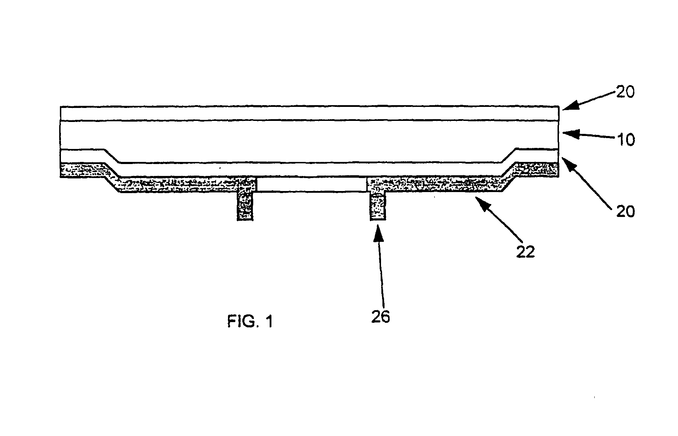

Au lieu de déposer des pistes conductrices en couches minces sur un substrat gravé (comme dans le cas de la figure 1), il est également possible selon la figure 11 de prévoir des trous métallisés 32 traversant le substrat 10 pour ramener la connexion électrique sur la face opposée 34 aux pointes 26.

## Revendications

1. Procédé de fabrication d'une carte à pointes multiple destinée notamment à tester une ou plusieurs puces semiconductrices ou des circuits intégrés avant leur encapsulation, et comprenant un substrat (10), l'une des faces étant dotée de pistes conductrices connectées à des contacts en forme de pointes (26), ledit procédé étant caractérisé par les étapes suivantes
- une couche mince métallique (22) est déposée par évaporation sous vide ou par pulvérisation cathodique sur l'une des faces isolée du substrat (10) monolithique, une gravure anisotrope du substrat (10) de silicium étant réalisée avant le dépôt de la couche mince métallique (22), ladite gravure étant non débouchante pour constituer une prise de contact électrique,
- les pistes conductrices sont obtenues au moyen d'une opération de photolithographie UV, faisant usage d'une résine photosensible , suivie d'une gravure de la couche mince métallique (22) selon l'endroit et la forme des pointes (26),
- on réalise par la suite une autre opération de photolithographie UV consistant à déposer une couche épaisse (24) de résine photosensible sur la couche mince gravée, la résine étant ensuite révélée avec le dessin (25) des pointes,
- on fabrique les pointes (26) par électroformage au moyen d'un bain d'ions métalliques permettant d'obtenir des plots électroformés correspondant à la forme des dessins (25),
- et la couche (24) restante de résine est finalement dissoute dans un bain de solvant pour obtenir l'implantation définitive des pointes (26) sur le substrat (10) monolithique.

2. Procédé de fabrication d'une carte à pointes multiple selon la revendication 1, caractérisé en ce que le substrat (10) est formé d'un matériau de base pouvant être entre autres, du silicium, Arsenium Galium, verre ou quartz.

3. Procédé de fabrication d'une carte à pointes multiple selon la revendication 1 ou 2, caractérisé en ce que la gravure anisotrope de substrat (10) intervient après une première photolithographie UV consistant à produire à travers un masque (14) une insolation locale d'une couche de résine (12) photosensible enduite préalablement sur une des faces du substrat (10), et que la gravure anisotrope est obtenue par immersion du substrat (10) de silicium dans de la potasse KOH.

4. Procédé de fabrication d'une carte à pointes multiple selon la revendication 1, caractérisé en ce que la couche mince métallique (22) est formée par un matériau à base soit de nickel, soit d'or, soit d'aluminium.

5. Procédé de fabrication d'une carte à pointes multiple selon la revendication 4, caractérisé en ce que l'électroformage des pointes (26) est effectué dans un bain de sulfanate de nickel, avec une densité de courant de l'ordre de 1A/dm2.

6. Carte à pointes multiple pour le test des puces semiconductrices, et comportant un substrat (10) traité selon le procédé de l'une des revendications 1 à 5 pour obtenir une densité élevée de pointes (26), le pas entre les différentes pointes étant au maximum de 100 microns.

7. Carte à pointes multiple selon la revendication 6, caractérisée en ce que les plots des pointes (26) possèdent des sections circulaires ou polygonales.

8. Carte à pointes multiple selon la revendication 6 ou 7, caractérisée en ce que chaque pointe (26) est déposée sur la couche mince (22) conductrice, avec ou sans ancrage dans le substrat (10).

9. Carte à pointes multiple selon la revendication 6 ou 7, caractérisée en ce que le substrat (10) est équipé d'un matériau amortisseur (30) agencé sous la couche mince (22) conductrice à l'opposé de la pointe (26) correspondante.

## Claims

1. A process for manufacturing a card with multiple tips designed in particular for testing one or more semiconductor chips or integrated circuits before encapsulation thereof, and comprising a substrate (10), one of the surfaces being provided with conducting strips connected to contacts in the form of tips (26), said process being characterized by the following stages
- a thin metal layer (22) is deposited by vapour deposition in a vacuum or by cathode sputtering on one of the insulated surfaces of the monolithic substrate (10), anisotropic etching of the silicon substrate (10) being performed before deposition of the thin metal layer (22) is performed, said etching being non-emergent to constitute an electrical contact connection point,
- the conducting strips are obtained by means of a UV photolithography operation making use of a photosensitive resin, followed by etching of the thin metal layer (22) according to the location and shape of the tips (26),
- another UV photolithography operation is then performed consisting in depositing a thick layer (24) of photosensitive resin on the thin etched layer, the resin then being revealed with the drawing (25) of the tips,
- the tips (26) are manufactured by electroforming by means of a metal ion bath enabling electroformed pads corresponding to the shape of the drawings (25) to be obtained,
- and the remaining layer (24) of resin is finally dissolved in a solvent bath to obtain the final implantation of the tips (26) on the monolithic substrate (10).

2. The process for manufacturing a card with multiple tips according to claim 1. characterized in that the substrate (10) is formed by a material with a base which may among others be silicon, Gallium Arsenide, glass or quartz.

3. The process for manufacturing a card with multiple tips according to claim 1 or 2, characterized in that anisotropic etching of the substrate (10) takes place after a first UV photolithography consisting in producing through a mask (14) a local insulation of a layer of photosensitive resin (12) previously deposited on one of the surfaces of the substrate (10). and that anisotropic etching is achieved by immersion of the silicon substrate (10) in potassium hydroxide KOH.

4. The process for manufacturing a card with multiple tips according to claim 1, characterized in that the thin metal layer (22) is formed by a nickel-, gold- or aluminium-based material.

5. The process for manufacturing a card with multiple tips according to claim 4, characterized in that electroforming of the tips (26) is performed in a nickel sulfamate bath with a current density of about 1A/dm².

6. A multiple-tip card for testing semiconductor chips, and comprising a substrate (10) processed according to the process of one of the claims 1 to 5 to obtain a high density of tips (26), the pitch between the different tips being a maximum of 100 microns.

7. The multiple-tip card according to claim 6, characterized in that the pads of the tips (26) have circular or polygonal cross sections.

8. The multiple-tip card according to claim 6 or 7, characterized in that each tip (26) is deposited on the thin conducting layer (22), with or without securing in the substrate (10).

9. The multiple-tip card according to claim 6 or 7, characterized in that the substrate (10) is equipped with a damping material (30) arranged under the thin conducting layer (22) opposite the corresponding tip (26).

## Patentansprüche

1. Verfahren zur Herstellung einer Karte mit mehreren Spitzen, die insbesondere zum Testen eines oder mehrerer Halbleiterchips oder integrierter Schaltungen vor ihrer Einkapselung bestimmt ist und ein Substrat (10) umfasst, wobei eine der Seiten mit führenden Spuren versehen ist, die mit Kontakten in Form von Spitzen (26) verbunden sind, welches Verfahren durch folgende Schritte gekennzeichnet ist:
- eine dünne Metallschicht (22) wird durch Aufdampfen im Vakuum oder Kathodenzerstäubung auf eine einzelne Seite des monolithischen Substrats (10) aufgebracht, wobei vor dem Aufbringen der dünnen Metallschicht (22) ein anisotropes Ätzen des Silizium-Substrats (10) erfolgt, welche Ätzung nicht durch das Substrat durchgeht, um eine elektrische Kontaktstelle zu bilden,
- die leitenden Spuren werden mittels eines UV-Fotolithografie-Arbeitsschritts unter Verwendung eines lichtempfindlichen Harzes hergestellt, woraufhin das Ätzen der dünnen Metallschicht (22) entsprechend den Stellen und der Form der Spitzen (26) erfolgt,
- anschließend wird ein weiterer UV-Fotolithografie-Arbeitsschritt durchgeführt, der in dem Aufbringen einer dicken Schicht (24) aus lichtempfindlichem Harz auf die geätzte dünne Schicht besteht, wobei in das Harz anschließend das Muster (25) der Spitzen eingeprägt wird,
- die Spitzen (26) werden durch Galvanoformung mittels eines Metallionenbades hergestellt, wodurch galvanogeformte Höcker entstehen, die der Form der Muster (25) entsprechen,
- und die verbleibende Harzschicht (24) wird anschließend in einem Lösungsmittelbad aufgelöst, damit die Spitzen (26) endgültig in dem monolithischen Substrat (10) eingearbeitet sind.

2. Verfahren zur Herstellung einer Karte mit mehreren Spitzen nach Anspruch 1, dadurch gekennzeichnet, dass das Substrat (10) aus einem Ausgangsmaterial besteht, das unter anderen Silizium, Galliumarsenid, Glas oder Quarz sein kann.

3. Verfahren zur Herstellung einer Karte mit mehreren Spitzen nach Anspruch 1 oder 2, dadurch gekennzeichnet, dass die anisotrope Ätzung des Substrats (10) nach einem ersten UV-Fotolithographie-Schritt erfolgt, der darin besteht, durch eine Maske (14) hindurch örtlich begrenzt eine Isolierung einer lichtempfindlichen Harzschicht (12) herzustellen, die vorab auf eine der Seiten des Substrats (10) aufgebracht wurde, und dass die anisotrope Ätzung durch Eintauchen des Siliziumsubstrats (10) in Kaliumhydroxid KOH erhalten wird.

4. Verfahren zur Herstellung einer Karte mit mehreren Spitzen nach Anspruch 1, dadurch gekennzeichnet, dass die dünne Metallschicht (22) aus einem Material auf Basis von entweder Nickel, Gold oder Aluminium hergestellt wird.

5. Verfahren zur Herstellung einer Karte mit mehreren Spitzen nach Anspruch 4, dadurch gekennzeichnet, dass die Galvanoformung der Spitzen (26) in einem Nickelsulfamatbad erfolgt, und zwar mit einer Stromdichte von 1A/dm².

6. Karte mit mehreren Spitzen zum Testen von Halbleiterchips, die ein Substrat (10) umfasst, das nach dem Verfahren eines der Ansprüche 1 bis 5 behandelt wurde, zum Erreichen einer hohen Dichte von Spitzen (26), wobei der Abstand zwischen den einzelnen Spitzen maximal 100 Mikron beträgt.

7. Karte mit mehreren Spitzen nach Anspruch 6, dadurch gekennzeichnet, dass die Höcker der Spitzen (26) einen kreisförmigen oder polygonalen Querschnitt aufweisen.

8. Karte mit mehreren Spitzen nach Anspruch 6 oder 7, dadurch gekennzeichnet, dass jede Spitze (26) auf die dünne, leitende Schicht (22) mit oder ohne Verankerung im Substrat (10) aufgebracht wird.

9. Karte mit mehreren Spitzen nach Anspruch 6 oder 7, dadurch gekennzeichnet, dass das Substrat (10) mit einem dämpfenden Material (30) versehen ist, das unter der dünnen, leitenden Schicht (22) gegenüber der jeweiligen Spitze (26) vorgesehen ist.
